# EUROPÄISCHE PATENTSCHRIFT

(11) **EP 0 339 381 B1**
(45) Veröffentlichungstag und Bekanntmachung des Hinweises auf die Patenterteilung: **13.01.1993**
(21) Anmeldenummer: 89106592.2
(22) Anmeldetag: 13.04.1989
(51) Int. Cl.: H02M 7/54, H03B 21/00

(54) **Schaltungsanordnung zur Erzeugung phasenverschobener sinusförmiger Spannungen**
Circuit arrangement for the generation of a dephased sine wave voltage
Circuit générateur d'une tension sinusoidale déphasée

(30) Priorität: 29.04.1988 DE 3814562
(43) Veröffentlichungstag der Anmeldung: 02.11.1989
(73) Patentinhaber: Deutsche Thomson-Brandt GmbH, 78003 Villingen-Schwenningen (DE)
(72) Erfinder: Gleim, Günter, D-7730 Villingen-Schwenningen 22 (DE)

(56) Entgegenhaltungen:
- DE-C- 800 308
- US-A- 3 003 697

## Beschreibung

Die Erfindung betrifft eine Schaltungsanordnung zur Erzeugung phasenverschobener, sinusförmiger Spannungen mit Hilfe eines Widerstandsumformers für die Umformung von Gleichstrom in Mehrphasenwechselstrom, wobei der Widerstandsumformer aus einer Anzahl von zu einem geschlossenen Kreis in Serie geschalteten Widerständen besteht und die sinusförmigen Spannungen an Verbindungspunkten der zusammengeschalteten Widerstände abnehmbar sind.

Eine derartige Anordnung ist z.B. in der DE-C-800 308 beschrieben, bei der über Bürsten und Schleifringe eine Gleichspannung zugeführt wird. Über einen Kollektor, dessen Lamellen mit zu einer Kette zusammengeschalteten Widerständen überbrückt sind, wird über Bürsten eine Wechselspannung abgenommen. Hierbei handelt es sich um einen großen mechanischen Aufwand, da mindestens vier Bürsten, ein Paar Schleifringe und ein Kollektor notwendig sind, wobei noch der Nachteil besteht, daß durch Übergangswiderstände infolge von Verunreinigungen das bekannte Bürstenfeuer entstehen kann.

Bei der angemeldeten Erfindung handelt es sich dagegen um eine elektronische Anordnung, die diesen Nachteil nicht besitzt, da die zyklische Umschaltung der Gleichspannungsquelle über elektronische Schaltstufen nahezu leistungslos erfolgt.

Der Erfindung liegt die Aufgabe zugrunde, diese Nachteile zu beseitigen. Diese Aufgabe wird durch die im Patentanspruch angegebene Maßnahme gelöst. Weitere vorteilhafte Ausgestaltungen der Erfindung ergeben sich aus den Unteransprüchen.

Phasenverschobene, sinusförmige Spannungen sind z.B. erforderlich bei der Ansteuerung von mehrsträngigen Motoren, bei denen den einzelnen Strängen möglichst gleichartige Spannungen mit im Kurvenverlauf geringsten Abweichnungen zugeführt werden müssen.

Nachstehend wird die Erfindung an einem Ausführungsbeispiel in Anwendung auf einen mehrsträngigen Motor mit Hilfe der Zeichnung erläutert.
- Figur 1: zeigt das der Erfindung zugrunde liegende Schaltungsprinzip
- Figur 2: zeigt die sich aus Figur 1 ergebenden Ansteuerspannungen
- Figur 3: zeigt ein detailliertes Ausführungsbeispiel der Erfindung
- Figur 4: zeigt ein Impulsdiagramm
- Figur 5: zeigt einen Ausschnitt der Schaltungsanordnung nach Figur 3.

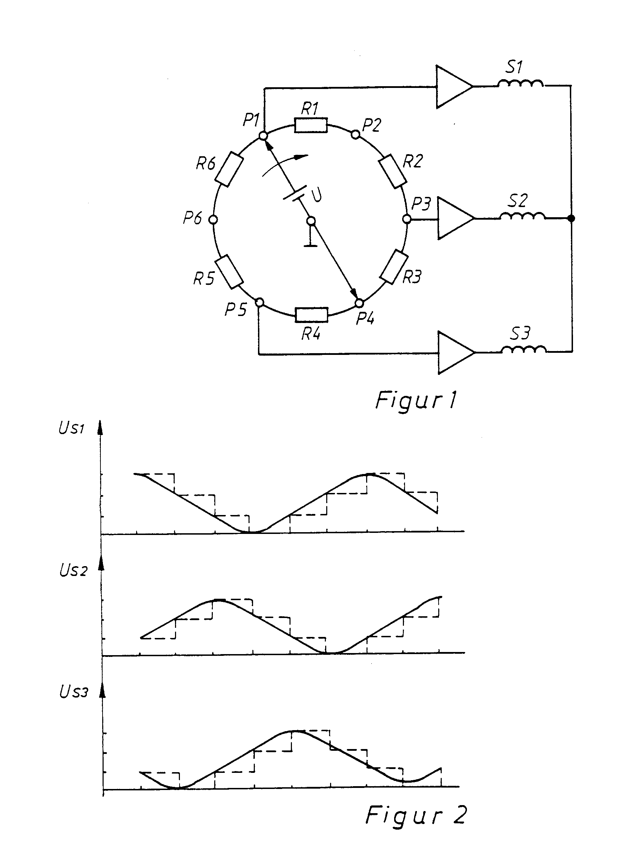

Figur 1 zeigt die prinzipielle Wirkungsweise des später im einzelnen beschriebenen Schaltungsbeispiels. Es sind hier sechs Widerstände R1 - R6 im Kreis angeordnet, die über die Schaltungspunkte P1 - P6 miteinander verbunden sind. Die Stränge S1, S2 und S3 eines z.B. dreisträngigen Motors sind z.B. in Sternschaltung symmetrisch mit den aus den Widerständen R1 - R6 bestehenden Widerstandsnetzwerk 7 mit den Schaltungspunkten P1, P3 und P5 verbunden. Es könnten aber auch die Schaltungspunkte P2, P4 und P6 sein. Wesentlich ist nur, daß zwischen den Anschlüssen mit den Motorsträngen jeweils die gleiche Anzahl der in ihrem Wert gleich großen Widerstände liegt. Die Motorstränge werden nun mit stufenförmig veränderbaren Spannungen angesteuert, indem durch eine Steuerschaltung eine Gleichspannungsquelle U in zyklischer Weiterschaltung jeweils an zwei diametral gegenüberliegende Punkte des Widerstandsnetzwerks 7 gelegt wird, z.B. zwischen die Schaltungspunkte P1, P4; P2, P5; P3, P6; P1, P4 usw. Es ist leicht einzusehen, daß die Abstufung der Ansteuerung der Motorstränge S1, S2 und S3 um so feiner ausgebildet ist, je mehr Widerstände das Widerstandnetzwerk 7 besitzt. Dabei ist zu beachten, daß die Anzahl der Widerstände geradzahlig ist, und daß der Quotient aus der Anzahl der Widerstände und der Anzahl der Motorstränge bzw. der Schaltungspunkte ganzzahlig ist.

Es entsteht an den Motorsträngen S1 - S3 ein Spannungsverlauf nach Figur 2.

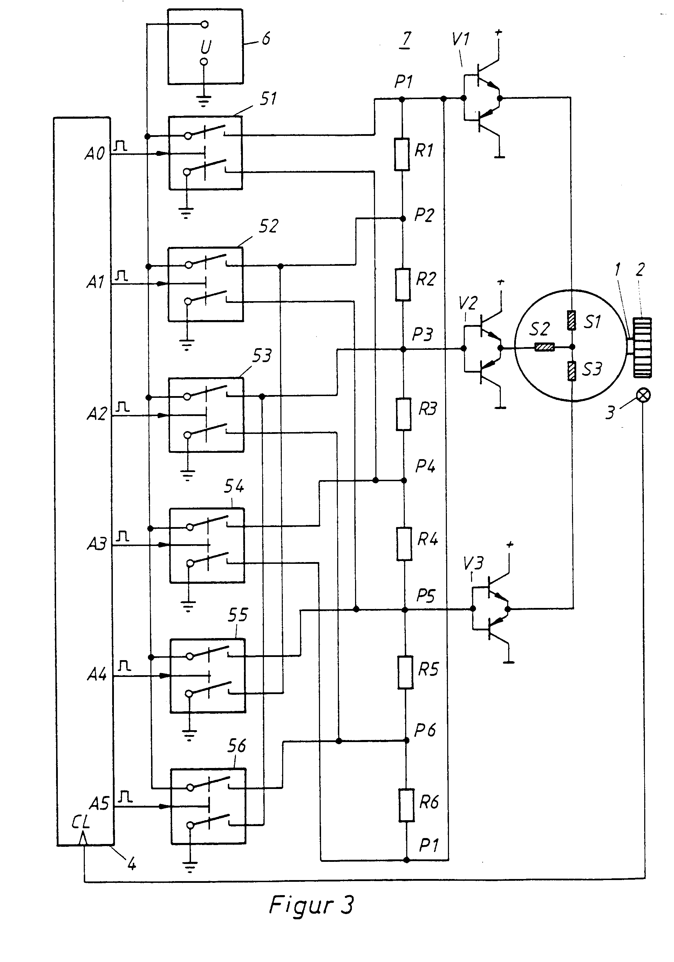

In Figur 3 ist ein Ausführungsbeispiel der Erfindung in ausführlicher Weise dargestellt.

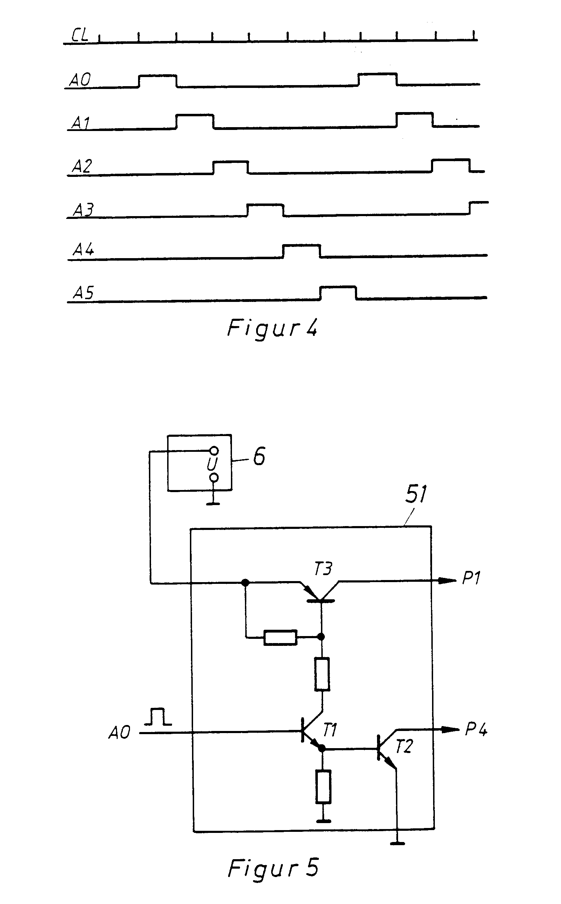

Ein auf der Achse 1 des mehrsträngigen Motors angeordneter Geber 2, z.B. ein Tachogenerator, erzeugt über dem Sensor 3 Impulse, die dem Clockeingang Cl eines Ringschieberegisters 4 zugeführt werden. Dieses Ringschieberegister 4 liefert in zyklischer Reihenfolge an seinen Ausgängen A0 - A5 Impulse, wie dies in Figur 4 dargestellt ist. Diese Impulse steuern nacheinander Schaltstufen 51 - 56, welche die Spannungsquelle 6 mit der Spannung U an die Schaltungspunkte P1, P4; P2, P5; P3, P6; P1, P4 usw. des Widerstandsnetzwerks 7 schaltet. Entsprechende Steuerspannungen nach Figur 2 gelangen an die Stromverstärker V1, V2 und V3 zur Ansteuerung der Stränge S1, S2 und S3.

Die Schaltstufen 51 - 56 können einen Aufbau nach Figur 5 besitzen. Der aus dem Ringschieberegister 4 erhaltene Impuls schaltet über einen Schalttransistor T1 den Transistor T2 durch, wodurch z.B. der Schaltungspunkt P4 mit dem einen Pol der Spannungsquelle 6 verbunden wird und infolge der Durchschaltung des Transistors T1 und die dadurch bewirkte Durchschaltung des Transistors T3 der andere Pol der Spannungsquelle 6 an den Schaltungspunkt P1 des Widerstandsnetzwerks 7 gelegt wird. Entsprechendes gilt für die übrigen Schaltungspunkte in Verbindung mit den diesen zugeordneten Schaltstufen.

## Patentansprüche

1. Schaltungsanordnung zur Erzeugung phasenverschobener, sinusförmiger Spannungen mit Hilfe eines Widerstandsumformers für die Umformung von Gleichstrom in Mehrphasenwechselstrom, wobei der Widerstandsumformer aus einer Anzahl von zu einem geschlossenen Kreis in Serie geschalteten Widerständen besteht und die sinusförmigen Spannungen an Verbindungspunkten der zusammengeschalteten Widerstände abnehmbar sind, **dadurch gekennzeichnet**, daß zwischen den Verbindungspunkten (P) die gleiche Anzahl von Widerständen liegt und daß eine Einrichtung (4, 51, 52, 53, 54, 55, 56) vorgesehen ist, welche eine Gleichspannung (U) in zyklischer Reihenfolge an das aus N(R) Widerständen bestehende Widerstandsnetzwerk (7) schaltet, daß zwischen den Polen der Gleichspannung (U) zwei parallele Zweige mit gleicher Anzahl (N(R)/2) Widerstände liegen.

2. Schaltungsanordnung nach Anspruch 1, **dadurch gekennzeichnet, daß** die Widerstände (R) des Widerstandsnetzwerks (7) gleiche Werte besitzen.

3. Schaltungsanordnung nach Anspruch 1 oder 2, **dadurch gekennzeichnet, daß** die Anzahl N(R) der Widerstände (R) des Widerstandsnetzwerks (7) geradzahlig ist und daß der Quotient aus der Anzahl N(R) der Widerstände (R) und der Anzahl N(P) der Verbindungspunkte (P) ganzzahlig ist.

4. Schaltungsanordnung nach Anspruch 1,2 oder 3, **dadurch gekennzeichnet, daß** die genannte Einrichtung ein Ringschieberegister (4) aufweist das durch die Impulse eines Generators getaktet wird und das eine der Anzahl N(R) der Widerstände (R) des Widerstandsnetzwerks (7) entsprechende Anzahl von Ausgängen (A) besitzt, an welche Schaltstufen (50) angeschlossen sind, welche die Gleichspannung (U) in zyklischer Reihenfolge von den Ausgängen (A) des Ringschieberegisters (4) gesteuert derart an das Widerstandsnetzwerk (7) schaltet, daß zwischen den Polen der Gleichspannungsquelle (U) zwei parallele Zweige des Widerstandsnetzwerks (7) mit gleicher Anzahl von Widerständen liegen.

## Revendications

1. Dispositif de circuit pour produire des tensions sinusoïdales déphasées à l'aide d'un transformateur de résistance pour la transformation de courant continu en courant alternatif polyphasé, le transformateur de résistance se composant d'une multitude de résistances montées en série en un cercle fermé et les tensions sinusoïdales pouvant être prélevées aux points de connexion des résistances interconnectées, **caractérisé en ce** que le même nombre de résistances se trouve entre les points de connexion (P) et qu'un dispositif (4, 51, 52, 53, 54, 55, 56) est prévu qui commute une tension continue (U) en séquence cyclique au réseau de résistances (7) composé de N résistances (R), que deux branches parallèles avec le même nombre (N(R)/2) de résistances se trouvent entre les pôles de la tension continue (U).

2. Dispositif de circuit selon la revendication 1, **caractérisé en ce** que les résistances (R) du réseau de résistances (7) possèdent les mêmes valeurs.

3. Dispositif de circuit selon la revendication 1 ou 2, **caractérisé en ce** que le nombre N(R) des résistances (R) du réseau de résistances (7) est pair et que le quotient du nombre N(R) des résistances (R) et du nombre N(P) des points de connexion est un nombre entier.

4. Dispositif de circuit selon la revendication 1, 2 ou 3, **caractérisé en ce** que le dispositif cité présente une mémoire à décalage cyclique (4) qui est rythmée par les impulsions d'un générateur et qui possède un nombre de sorties (A) qui correspond au nombre N(R) des résistances (R) du réseau de résistances (7), sorties auxquelles des étages de commutation (50) sont raccordés qui commutent la tension continue (U) commandée en séquence cyclique par les sorties (A) de la mémoire à décalage cyclique (4) sur le réseau de résistances (7) de telle manière que deux branches parallèles du réseau de résistances (7) avec le même nombre de résisances se trouvent entre les pôles de la source de tension continue (U).

## Claims

1. A circuit arrangement for generating phase-displaced, sinusoidal voltages by means of a resistance converter for converting direct current into multi-phase alternating current, wherein the resistance converter comprises a number of resistors connected in series to form a closed circuit, and the sinusoidal voltages can be tapped at connection points of the interconnected resistors, characterised in that on equal number of resistors is located between the connection points (P), that a system (4, 51, 52, 53, 54, 55, 56) is provided to connect a DC voltage (U) in cyclic sequence to the resistance network (7) comprising N(R) resistors, and that two parallel branches with an equal number (N(R)/2) of resistors are located between the poles of the DC voltage U.

2. An arrangement according to claim 1, characterised in that the resistors (R) of the resistance network (7) have equal values.

3. An arrangement according to claim 1 or 2, characterised in that the number N(R) of resistors (R) in the resistance network (7) is an even number, and that the quotient of the number N(R) of resistors (R) and the number N(P) of connection points (P) is an integer.

4. An arrangement according to claim 1, 2 or 3, characterised in that said system has a cyclic shift register (4), which is clocked by the pulses of a generator and which has a number of outputs (A) equal to the number N(R) of resistors (R) in the resistance network (7), and that the outputs (A) are connected to switching steps (50), which switch the DC voltage (U) to the resistance network (7) in cyclic sequence, controlled by the outputs (A) of the register (4), in such a way that two parallel branches of the resistance network (7) with an equal number of resistors are located between the poles of the DC voltage source (U).
